(19)

**Europäisches Patentamt**

**European Patent Office**

**Office européen des brevets**

(11) **EP 2 965 538 B1**

(12) **EUROPÄISCHE PATENTSCHRIFT**

(45) Veröffentlichungstag und Bekanntmachung des Hinweises auf die Patenterteilung:
**13.12.2017 Patentblatt 2017/50**

(51) Int Cl.:
*G06F 17/10* (2006.01)   *G06F 17/50* (2006.01)
*H04R 27/00* (2006.01)   *H04R 5/02* (2006.01)
*H04S 7/00* (2006.01)

(21) Anmeldenummer: **14724993.2**

(22) Anmeldetag: **05.03.2014**

(86) Internationale Anmeldenummer:
**PCT/DE2014/100077**

(87) Internationale Veröffentlichungsnummer:
**WO 2014/135155 (12.09.2014 Gazette 2014/37)**

(54) **VERFAHREN ZUM BESTIMMEN EINER KONFIGURATION FÜR EINE LAUTSPRECHERANORDNUNG ZUM BESCHALLEN EINES RAUMS UND COMPUTERPROGRAMMPRODUKT**

METHOD FOR DETERMINING A CONFIGURATION FOR A LOUDSPEAKER ARRANGEMENT FOR RADIATING SOUND INTO A SPACE AND COMPUTER PROGRAM PRODUCT

PROCÉDÉ DE DÉTERMINATION D'UNE CONFIGURATION POUR UN AGENCEMENT DE HAUT-PARLEURS POUR SONORISER UNE SALLE ET PRODUIT-PROGRAMME D'ORDINATEUR

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **08.03.2013 DE 102013102356**

(43) Veröffentlichungstag der Anmeldung:
**13.01.2016 Patentblatt 2016/02**

(73) Patentinhaber: **SDA Software Design Ahnert GmbH**
**13189 Berlin (DE)**

(72) Erfinder: **FEISTEL, Stefan**
**13189 Berlin (DE)**

(74) Vertreter: **Bittner, Thomas L.**
**Boehmert & Boehmert**
**Anwaltspartnerschaft mbB**
**Pettenkoferstrasse 22**
**80336 München (DE)**

(56) Entgegenhaltungen:
EP-A2- 1 355 514   WO-A1-2011/080499
US-A1- 2009 144 036

**Beschreibung**

Die Erfindung betrifft ein Verfahren zum Bestimmen einer Konfiguration für eine Lautsprecheranordnung zum Beschallen eines Raumes sowie ein Computerprogrammprodukt.

Hintergrund

Lautsprechertechnik und Beschallungsanlagen werden für die Wiedergabe oder Verstärkung von akustischen Signalen eingesetzt. Hierbei besteht ein wesentliches Ziel der Konzeption und Einrichtung dieser Systeme darin, dass die Zuhörer bzw. die zu beschallenden Flächen akustisch möglichst optimal erreicht werden. Die Qualität der Beschallung wird hierbei beschrieben durch eine einerseits räumlich und spektral möglichst gleichmäßige Schallübertragung sowie andererseits durch eine möglichst hohe Übertragungsamplitude bzw. - verstärkung. Ferner können raumakustische Kriterien eine Rolle spielen, zum Beispiel die Erhöhung des Anteils früher Reflexionen und / oder die Vermeidung von schädlichen, späten Reflexionen oder Echos.

Entsprechend muss die Lautsprecheranlage so ausgewählt und eingestellt (konfiguriert) werden, dass die Anforderungen an die Übertragungsqualität erreicht werden. Da die Konfigurationsmöglichkeiten bezüglich des Beschallungssystems sehr vielfältig und die zu beschallenden Bereiche in der Regel geometrisch komplex sind, gibt es für dieses Problem in Praxis aber keine einfache, offensichtliche Lösung. Daher wird bei der Planung von Beschallungssystemen regelmäßig iterativ vorgegangen, nämlich so, dass verschiedene Konfigurationsvarianten bezüglich der eingesetzten Lautsprechermodelle, -positionen, -winkelungen und / oder -einstellungen und der daraus resultierenden, erwarteten akustischen Ergebnisse sukzessive entwickelt und gegenübergestellt werden. Moderne Simulationssoftware für Beschallungssysteme erlaubt professionellen Planungsbüros die Berechnung solcher akustischen Ergebnisse in schneller und vergleichsweise genauer Form, zum Teil kann der iterative Vorgang auch automatisiert durchgeführt werden. Solche Aspekte werden beispielsweise in Martin Audio, The Edge, Issue Eleven, April 2005, (http://www.martin-audio.com/edge/pdfs/ MartinAudio_ TheEdge_11.pdf) zusammengefasst und praxisnah am Beispiel dargestellt.

Für die automatisierte Iteration von Konfigurationsvarianten ist es notwendig, dass ein eindeutiges Bewertungskriterium für die Beschallungsqualität, bezogen auf den jeweils betrachteten Fall, vorgegeben wird. Dieses definiert für jede Konfigurationsvariante, ob sie einer anderen vorzuziehen ist oder dieser unterlegen ist. In der Numerik und der Optimierungstheorie wird hierbei von einer Zielfunktion gesprochen ("Objective Function", vgl. zum Beispiel S. Boyd, L. Vandenberghe, Convex Optimization, Cambridge University Press (7th ed. 2009), http://www.stanford.edu/-boyd/cvxbook/bv_cvxbook.pdf). Ziel der Optimierung ist es dann üblicherweise, das Ergebnis der Zielfunktion zu minimieren, indem diese für verschiedene Konfigurationsvarianten bestimmt wird. Die Konfiguration mit dem kleinsten Ergebnis der Zielfunktion entspricht dann üblicherweise der optimalen Konfiguration gemessen am definierten Bewertungskriterium.

Häufig ist die Anzahl der Konfigurationsvarianten sehr groß oder sogar unendlich groß. In solchen Fällen kann nur eine Teilmenge dieser Varianten geprüft und es wird möglicherweise nur ein Ergebnis gefunden, das nicht optimal hinsichtlich aller möglichen Konfigurationen ist. Die Problemstellung, wie auf Basis einer gegebenen Zielfunktion ein möglichst großer Teil aller Konfigurationsvarianten abgedeckt wird und man möglichst dicht an das optimale Ergebnis herankommt, ist ein Kernpunkt der klassischen Optimierungstheorie.

Im Stand der Technik (vgl. In Martin Audio, The Edge, Issue Eleven, April 2005) wird als typisches Bewertungskriterium die gleichmäßige Verteilung des Schalldrucks über den Hörerflächen und der Frequenz genannt. Mögliche Konfigurationsvarianten entstehen durch die unterschiedliche Platzierung und Winkelung des Lautsprechersystems relativ zu den Empfangsflächen. Angedeutet wird auch die Möglichkeit, bei dem Erstellen von Konfigurationsvarianten die Einstellungen der Steuereinheit der Lautsprecheranordnung und des Verstärkers zu verändern, zum Beispiel Filtereinstellungen. Das automatisierte Konfigurationsverfahren iteriert in diesem Fall dann durch eine Anzahl von verschiedenen Lautsprecherpositionen und -winkeln, um für jede Konfigurationsvariante die Gleichmäßigkeit des Schalldrucks zu ermitteln und dann eine oder mehrere Konfigurationsvarianten vorzuschlagen, die eine möglichst hohe Gleichmäßigkeit erreichen.

Das Dokument WO 2008 / 047089 A2 offenbart ein iteratives Verfahren der vorgenannten Art zum computerbasierten Bestimmen einer Konfiguration für eine Lautsprecheranordnung, mit der ein Veranstaltungsraum beschallt werden soll. Iterativ werden auf bekannte Art und Weise mehrere Kandidatenkonfigurationen untersucht, für die dann das zugehörige Schallfeld in Verbindung mit dem zu beschallenden Veranstaltungsraum auf Basis eines Abstrahlungsmodells berechnet wird. Für eine durch das Schallfeld bestimmte Zielfunktion wird sodann jeweils ein Wert bestimmt, der im Rahmen des iterativen Verfahrens minimiert werden soll.

Das Dokument EP 1 355 514 A2 beschreibt ein Verfahren zum Betreiben einer automatischen Beschallungssystem-Designvorrichtung. Ein mehrstufiges Optimierungsverfahren wird angewendet, um das Beschallungssystem zu optimieren, wobei in Optimierungsschritten auch eine iterative Optimierung stattfindet. Ein Optimierungsschritt sieht hierbei ein Schallfeldsimulation für Kandidatenkonfigurationen der Lautsprecheranordnung vor, für die eine Bewertung mittels einer Zielfunktion ausgeführt wird.

Das Dokument WO 2011/080499 A1 offenbart ein computer-implementiertes iteratives Optimierungsverfahren zum Bestimmen einer Konfiguration für eine Audio-Verarbeitungsoperation.

Das Dokument US 2009/0144036 A1 beschreibt das Konfigurieren / Simulieren eines Beschallungssystems.

Zusammenfassung

Aufgabe der Erfindung ist es, ein Verfahren zum Bestimmen einer Konfiguration für eine Lautsprecheranordnung zum Beschallen eines offenen oder geschlossenen Raums sowie ein Computerprogrammprodukt anzugeben, mit dem das automatisierte Konfigurieren von LautSprecheranordnungen zur verbesserten akustischen Abstrahlung in den zu beschallenden Raum verbessert wird.

Zur Lösung der Aufgabe sind ein Verfahren zum Bestimmen einer Konfiguration für eine Lautersprecheranordnung zum Beschallen eines Raums nach dem unabhängigen Anspruch 1 sowie ein Computerprogrammprodukt nach dem unabhängigen Anspruch 12 geschaffen. Vorteilhafte Ausgestaltungen sind Gegenstand von abhängigen Unteransprüchen.

Es ist ein Verfahren zum Bestimmen einer Konfiguration für eine Lautersprecheranordnung vorgesehen, mit der ein Raum zu beschallen ist, beispielsweise ein Veranstaltungsraum. Die Konfiguration der Lautsprecheranordnung umfasst Konfigurationsparameter, mit denen die Lautsprecheranordnung für die Beschallung des konkret betrachteten Raums eingerichtet (konfiguriert) wird. Bei dem Verfahren wird zunächst in einem Computer, der wahlweise in einen Computer-Netzwerkstruktur eingebunden ist, eine anfängliche Konfiguration mit anfänglichen Konfigurationsparametern für die Lautsprecheranordnung bereitgestellt. Dieses erfolgt beispielsweise mittels Übergabe elektronischer Informationen betreffend die anfängliche Konfiguration an einen Computer, mit dem dann die Optimierung ausgeführt wird. Auch kann vorgesehen sein, dass die Anfangskonfiguration, welche den Ausgangspunkt für ein anschließendes Optimierungsverfahren bildet, im Computer über empfangene Benutzereingaben und / oder experimentelle Messdaten bereitgestellt wird.

Sodann ist das Bestimmen von Konfigurationen mit jeweils zugeordneten Konfigurationsparametern mit Hilfe eines zielfunktionsbasierten Optimierungsverfahrens vorgesehen. Derartige Optimierungsverfahren sind als solche in verschiedenen Ausführungsformen bekannt und dienen üblicherweise der Optimierung einer Ausgangskonfiguration mit Hilfe numerischer Methoden. Eine Zielfunktion kann herangezogen werden, um das Ergebnis einzelner Optimierungsschritte zu bewerten. Bei dem Optimierungsverfahren werden, ausgehend von der anfänglichen Konfiguration, in dem Computer iterativ die folgenden Schritte ausgeführt. Zu einer Kandidatenkonfiguration wird ein Schallfeld für den zu beschallenden Raum und / oder Teile hiervon mittels Simulation bestimmt. Der Simulation wird ein Modell für die Schallabstrahlung der Lautsprecheranordnung in den zu beschallenden Raum zu Grunde gelegt. Derartige Abstrahlungsmodelle sind als solche in verschiedenen Ausgestaltungen bekannt. Das so bestimmte Schallfeld ist der momentan untersuchten Kandidatenkonfiguration für die Lautsprecheranordnung zugeordnet, da der Simulationsschritt unter Berücksichtigung der Kandidatenkonfigurationsparameter erfolgt. Sodann wird ein der Kandidatenkonfiguration und dem simulierten Schallfeld zugeordneter Wert einer Zielfunktion bestimmt. Bei dem iterativen Prozess wird dann eine neue Kandidatenkonfiguration für die Lautsprecheranordnung ausgewählt, um die Schritte zur Schallfeldsimulation und zur Bestimmung des Wertes der Zielfunktion zu wiederholen.

Aus den erzeugten Kandidatenkonfigurationen wird in Abhängigkeit von wenigstens einem Auswahlkriterium eine Konfiguration mit Konfigurationsparametern für die Lautsprecheranordnung ausgewählt. Das Auswahlkriterium berücksichtigt zumindest die für die Zielfunktion bestimmten Werte der Kandidatenkonfigurationen. Beispielsweise kann vorgesehen sein, dass die Kandidatenkonfiguration mit dem niedrigsten Wert der Zielfunktion ausgewählt wird.

Bei dem iterativen Optimierungsverfahren wird eine Zielfunktion mit mehreren die Funktion bestimmenden Parametern verwendet, die neben einem oder mehreren schallfeldabhängigen Funktionstermen zumindest einen schallfeldunabhängigen Funktionsterm aufweist. Während die schallfeldabhängigen Funktionsterme abhängig sind von dem simulierten Schallfeld, weshalb sie auch als akustische Funktionsterme bezeichnet werden können, hängen die schallfeldunabhängigen Funktionsterme gerade nicht vom simulierten Schallfeld ab, sind also insoweit nicht-akustische Funktionsterme. Eine Abhängigkeit besteht für die schallfeldunabhängigen Funktionsterme von einem oder mehreren der von der Konfiguration umfassten Konfigurationsparameter. Die schallfeldunabhängigen Funktionsterme sind entkoppelt von dem mittels Simulation bestimmten Schallfeld. In die schallfeldabhängigen Funktionsterme gehen Eigenschaften des simulierten Schallfeldes ein, wohingegen die schallfeldunabhängigen Funktionsterme gerade frei von solchen Eigenschaften sind.

Die Zielfunktion kann einen oder mehrere schallfeldunabhängige Funktionsterme enthalten.

Die Zielfunktion kann mehrere Funktionsbestandteile umfassen, die unterschiedliche Eigenschaften des simulierten Schallfeldes betreffen, beispielsweise eine Schallpegelhöhe in unterschiedlichen Raumbereichen des zu beschallenden Raums. Die Funktionsbestandteile dienen der Bewertung von Eigenschaften oder Optimierungskriterien für die mehreren Kandidatenkonfigurationen. Auf diese Weise wird eine Vergleichbarkeit der Kandidatenkonfigurationen und der sich hieraus ergebenden simulierten Schallfelder für den zu beschallenden Raum erreicht. Die mehreren Funktionsbestandteile hängen ihrerseits von einem oder mehreren schallfeldabhängigen Funktionstermen und / oder einem oder mehreren schallfeldunabhängigen Funktionstermen ab. Die Zielfunktionsbestandteile können über beliebige logische Verknüpfungen miteinander in Beziehung stehen und so eine Gesamtzielfunktion bilden, für die dann schließlich ein Wert bestimmt wird, welcher zum Vergleich der Kandidatenkonfigurationen herangezogen wird.

Bei der Lautsprecheranordnung kann es sich um ein Line-Array von Lautsprecherelementen handeln. Auch andere Anordnungsformen können vorgesehen sein, zum Beispiel eine gebogene Linienanordnung, eine flächige Anordnung und / oder eine räumliche Anordnung von Lautsprecherelementen.

Eine Weiterbildung sieht vor, dass der schallfeldunabhängige Funktionsterm und / oder ein anderer schallfeldunabhängiger Funktionsterm abhängig sind von mindestens einem Filterparameter für einen Filter in einer Steuereinrichtung zum Ansteuern der Lautsprecheranordnung. Es kann eine Abhängigkeit von einem Verstärkungsfaktor und / oder einer Verzögerungszeit gegeben sein. Es kann auch eine Abhängigkeit der Zielfunktion von mehr als zwei schallfeldunabhängigen Funktionstermen bestehen. Filtereinrichtungen für Lautsprecherelemente oder Lautsprecheranordnungen sind als solche in verschiedenen Ausführungsformen bekannt.

Bei einer Ausgestaltung kann vorgesehen sein, dass der schallfeldunabhängige Funktionsterm und / oder der andere schallfeldunabhängige Funktionsterm abhängig sind von der Glattheit des Frequenzganges eines oder mehrerer Filter in der Steuereinrichtung zum Ansteuern der Lautsprecheranordnung. Auch hier kann eine Abhängigkeit von mehr als zwei schallfeldunabhängigen Funktionstermen gegeben sein.

Eine Ausführungsform sieht vor, dass der schallfeldunabhängige Funktionsterm und / oder der andere schallfeldunabhängige Funktionsterm abhängig sind von einer räumlichen Position eines oder mehrerer Lautsprecherelemente der Lautsprecheranordnung.

Bevorzugt sieht eine Fortbildung vor, dass der schallfeldunabhängige Funktionsterm und / oder der andere schallfeldunabhängige Funktionsterm abhängig sind von einer räumlichen Ausrichtung eines oder mehrerer Lautsprecherelemente der Lautsprecheranordnung.

Die in den vorangehenden Abschnitten beschriebenen Funktionsterme, welche einzeln oder in beliebigen Kombinationen in die Zielfunktion eingehen können, sind Beispiele für Funktionsterme, die unabhängig vom simulierten Schallfeld sind, hiervon also nicht beeinflusst werden. Während bei bekannten Verfahren in die Zielfunktion stets nur Funktionsterme eingehen, die ihrerseits von der Akustik, also dem simulierten Schallfeld abhängen, ist hier vorgesehen, auch hiervon nicht abhängige, also nicht akustische Funktionsterme in die Zielfunktion und somit in die Berechnung des Wertes der Zielfunktion einzubeziehen. Es hat sich überraschend gezeigt, dass die Einbeziehung solcher Funktionsterme eine Verbesserung der automatischen Konfiguration der Lautsprecheranordnung bezüglich der akustischen Eigenschaften der Anordnung (Schallabstrahlung) ermöglicht.

Bei einer Ausgestaltung kann vorgesehen sein, dass die Zielfunktion mehrere Funktionsbestandteile aufweist, wobei zumindest einer der mehreren Funktionsbestandteile nur von dem schallfeldunabhängigen Funktionsterm und / oder dem anderen schallfeldunabhängigen Funktionsterm abhängig ist. Die Zielfunktion kann ein oder mehrere Funktionsbestandteile aufweisen, die ausschließlich von einem oder mehreren schallfeldabhängigen Funktionstermen abhängen. Die Zielfunktion kann ergänzend oder alternativ einen oder mehrere Funktionsbestandteile aufweisen, die von einem oder mehreren schallfeldabhängigen sowie einem oder mehreren schallfeldunabhängigen Funktionstermen abhängen.

Es kann vorgesehen sein, dass die Zielfunktion einen Funktionsbestandteil aufweist, mit dem, bei gegebener Kandidatenkonfiguration für die Lautsprecheranordnung, eine Abweichung des Schallpegels in einem Teilbereich des Raumes von einem Sollwert bewertet wird. Je niedriger der für den Funktionsbestandteil bei der Optimierung der Zielfunktion bestimmte Wert ist, umso näher ist der Schallpegel in dem betrachteten Teilbereich des Raumes an dem Sollwert.

Bei einer Ausgestaltung kann vorgesehen sein, dass die Zielfunktion einen Funktionsbestandteil aufweist, mit dem, bei gegebener Kandidatenkonfiguration für die Lautsprecheranordnung und unabhängig von einer Gesamtlautstärke, die Höhe des Schallpegels in einem Teilbereich des Raumes bewertet wird. Je niedriger der Wert des Funktionsbestandteils bei der Optimierung der Zielfunktion ist, umso höher ist der Schallpegel in dem betrachteten Teilbereich des Raumes.

Eine Ausführungsform sieht vor, dass die Zielfunktion einen Funktionsbestandteil aufweist, mit dem, bei gegebener Kandidatenkonfiguration für die Lautsprecheranordnung und unabhängig von der Gesamtlautstärke, eine Minimierung der Schallabstrahlung in einen anderen Teilbereich des Raumes bewertet wird. Je niedriger der Wert des Funktionsbestandteils bei der Optimierung der Zielfunktion ist, umso geringer ist die Schallabstrahlung in den anderen Teilbereich des Raumes. Die Optimierung (Minimierung) kann bis zu einer Minderung der Schallabstrahlung führen, bei der der Schallpegel in dem anderen Teilbereich des Raumes unterhalb einer Nachweisbarkeitsgrenze liegt (Vermeidung von Schallabstrahlung).

Es kann vorgesehen sein, dass die Zielfunktion einen Funktionsbestandteil aufweist, mit dem die Gleichmäßigkeit einer elektrischen Lastverteilung auf zumindest einen Teil der Lautsprecherelemente der Lautsprecheranordnung bewertet wird und der nur von einem oder mehreren schallfeldunabhängigen Funktionstermen abhängt.

Bei einer Ausgestaltung kann vorgesehen sein, dass im Computer, von der ausgewählten Konfiguration ausgehend, Steuerungsdaten für die Steuereinrichtung zum Ansteuern der Lautsprecheranordnung erzeugt und an einer Schnittstelle bereitgestellt werden.

Beschreibung von Ausführungsbeispielen

In Folgenden werden weitere Ausführungsbeispiele unter Bezugnahme auf Figuren einer Zeichnung näher erläutert. Hierbei zeigen:

Fig. 1    eine schematische Darstellung einer Lautsprecheranordnung,

Fig. 2    eine schematische Darstellung einer Anordnung mit Lautsprecher und einem zu beschallenden Raum,

Fig. 3    für ein simuliertes Schallfeld eine räumliche Pegelverteilung in Seitenansicht, bei einer Frequenz von 1000 Hz, und eine Pegelverteilung auf einem linienförmigen Verbotsbereich (linke Kurve) und einem ebenfalls linienförmigen Hörbereich (rechte Kurve) für den nicht optimierten Fall,

Fig. 4    für ein simuliertes Schallfeld Darstellungen vergleichbar zu Fig. 3 mit maximierter mittlerer Schallleistung, wobei die mittlere, dem Lautsprechersystem zugeführte elektrische Leistung konstant gehalten wurde,

Fig. 5    für ein simuliertes Schallfeld Darstellungen vergleichbar zu Fig. 3 mit maximal gleichmäßiger Schallpegelverteilung in einem Hörbereich (optimiert nach dem Glattheitskriterium),

Fig. 6    für ein simuliertes Schallfeld Darstellungen vergleichbar zu Fig. 3 mit minimaler Schallleistung in einem Verbotsbereich,

Fig. 7    eine schematische Darstellung eines Ablaufdiagramms für ein Verfahren zum Bestimmen einer Konfiguration einer Lautsprecheranordnung,

Fig. 8    für ein simuliertes Schallfeld Darstellungen vergleichbar zu Fig. 3, wobei ein normiertes Schallleistungskriterium und das Glattheitskriterium gleichzeitig und mit gleichem Gewicht optimiert wurden,

Fig. 9    für ein simuliertes Schallfeld Darstellungen vergleichbar zu Fig. 3 für den Fall einer Optimierung der Zielfunktion, bei der das Leistungskriterium stärker (hundertfach) gewichtet ist,

Fig. 10    für ein simuliertes Schallfeld Darstellungen vergleichbar zu Fig. 3, wobei das Glattheitskriterium und die Vermeidung der Abstrahlung auf einen Verbotsbereich gleichzeitig und mit gleichem Gewicht optimiert wurden,

Fig. 11    für ein simuliertes Schallfeld Darstellungen vergleichbar zu Fig. 3, wobei das Glattheitskriterium und die Gleichmäßigkeit der Filteramplituden gleichzeitig optimiert wurden,

Fig. 12    für ein simuliertes Schallfeld Darstellungen vergleichbar zu Fig. 3, wobei das normierte Schallleistungskriterium, das Glattheitskriterium und die Gleichmäßigkeit der Filteramplituden gleichzeitig optimiert wurden,

Fig. 13    eine grafische Darstellung des Amplitudengangs (oben) und des Phasengangs (unten) einer Filterübertragungsfunktion als Ergebnis einer Optimierung und

Fig. 14    vergleichbare Darstellungen wie in Fig. 13, aber bei zusätzlicher Verwendung eines Funktionsbestandteils $F_5$ bei der Optimierung.

Für eine Beschallungsanlage können verschiedene Konfigurationsvarianten geschaffen werden, zum Beispiel mittels unterschiedlicher Lautsprechermodelle, -positionen, -winkel, -filtereinstellungen oder dergleichen. Solche variierbaren Größen werden Konfigurationsparameter genannt. Wie eingangs geschildert erfolgt die Bewertung eines Beschallungskonzepts in der Praxis über die hörbaren (akustischen) Eigenschaften des Lautsprechersystems, also über das Schallfeld an den Empfangsorten und im Umfeld der Anlage. Daher wird regelmäßig vorgesehen, die Zielfunktion auf Basis des Schallfelds zu definieren, nämlich als Maß dafür, inwieweit die berechneten akustischen Eigenschaften von vorgegebenen Anforderungen abweichen.

Zur Beschreibung des Schallfeldes wird der zu beschallende Bereich hinreichend dicht in repräsentativer Weise mit Empfangsorten überdeckt, so dass für jeden Empfangsort $i = 1,...,N_H$ eine von der Frequenz $f$ und den Konfigurationsparametern $p_1,...,p_N$ abhängige Gesamtübertragungsfunktion $H_i(f,p_1,...,p_N)$ der Beschallungsanlage zum jeweiligen Empfangsort (bei geeigneter Normierung) gegeben ist. Die Bewertung der Beschallungseigenschaften erfolgt dann mittels der Schallleistungen

$$P_i(f, p_1, ..., p_N) = |H_i(f, p_1, ..., p_N)|^2$$

und der in dB gemessenen Schallpegel

$$L_i(f, p_1, ..., p_N) = 10 \log_{10} P_i(f, p_1, ..., p_N)$$

an den Empfangsorten $i = 1, ... , N_H$.

Ein wichtiges Bewertungskriterium ist die reziproke mittlere Schallleistung im Hörbereich, gegeben durch die Funktion

$$P^{-1}(f, p_1, \ldots, p_N) = \left[\frac{1}{N_H}\sum_{i=1}^{N_H} P_i(f, p_1, \ldots, p_N)\right]^{-1},$$

die es unter Variation der Konfigurationsparameter $p_1, \ldots, p_N$ zu minimieren gilt, um maximale Schallleistung im Hörbereich zu erzielen.

Ein weiteres Bewertungskriterium ist das "Glattheitskriterium" $S$, das die Abweichung der räumlichen Schallpegelverteilung vom Mittelwert oder von einer Sollverteilung beschreibt:

$$S(f, p_1, \ldots, p_N) = \frac{1}{N_H}\sum_{i=1}^{N_H}\left(L_i(f, p_1, \ldots, p_N) - \bar{L}(f, p_1, \ldots, p_N) - L_{t,i}(f)\right)^2.$$

Bei $\bar{L}(f, p_1, \ldots, p_N)$ handelt es sich um den über alle Empfangsorte gemittelten Schallpegel, während $L_{t,i}(f)$ eine Sollabweichung des Schallpegels am $i$-ten Empfangsort vom Mittelwert angibt, entsprechend einer vorgegebenen räumlichen Sollverteilung.

Ein anderes Bewertungskriterien betrifft Bereiche, deren Beschallung vermieden werden soll (Verbotszonen), etwa um schädliche Reflexionen oder die Schallemission aus dem Gebäude heraus zu vermindern oder die Monitorbeschallung des Bühnenbereichs möglichst wenig zu stören. Zur Formulierung eines solchen Kriteriums wird analog zur Überdeckung des Hörbereichs mit Empfangsorten diese "Verbotszone" mit Empfangsorten überdeckt, so dass man für jeden Empfangsort $i = 1, \ldots, N_V$ eine Gesamtübertragungsfunktion $\tilde{H}_i(f, p_1, \ldots, p_N)$ der Beschallungsanlage zum jeweiligen Empfangsort erhält. Analog werden Schallleistungen $\tilde{P}(f, p_1, \ldots, p_N) = |\tilde{H}_i(f, p_1, \ldots, p_N)|^2$ definiert, und die mittlere Schallleistung im verbotenen Bereich, gegeben durch

$$\tilde{P}(f, p_1, \ldots, p_N) = \frac{1}{N_V}\sum_{i=1}^{N_V}\tilde{P}_i(f, p_1, \ldots, p_N),$$

ist zu minimieren.

Diese Bestandteile lassen sich einzeln verwenden oder auf verschiedene Art zu einer Zielfunktion kombinieren, zum Beispiel als Summe oder als logische Verknüpfung.

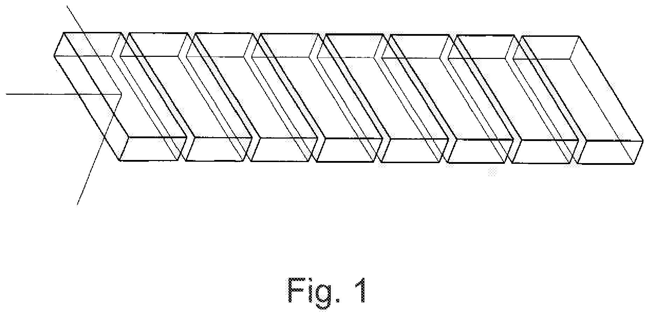

Zur Illustration dieses Sachverhalts und der nachfolgenden Ausführungen wird ein Lautsprechersystem mit akustischen Ergebnissen exemplarisch dargestellt in Fig. 1. Hierbei handelt es sich um eine vertikale Anordnung von acht horizontal ausgerichteten Lautsprecherboxen. Das System ist etwa 4 m lang und befindet sich 4 m über dem Boden. Der zu beschallende Empfangsbereich, bei dem es sich zum Beispiel um einen Teil eines Veranstaltungsortes (Akustikraum) handelt, erstreckt sich vor dem System (rechts) von 10 m bis etwa 60 m, mit einer Ohrhöhe von 1,2 m über dem Boden. Ein nicht zu beschallender Bühnenbereich befindet sich hinter dem System (links) von etwa 2 m bis 10 m. Jede der Lautsprecherboxen besitzt acht Schallwandler, die einzeln mittels Filterübertragungsfunktionen gesteuert werden. In diesem Fall stellen demnach die komplexwertigen Amplituden der Filterfrequenzgänge die Konfigurationsparameter dar.

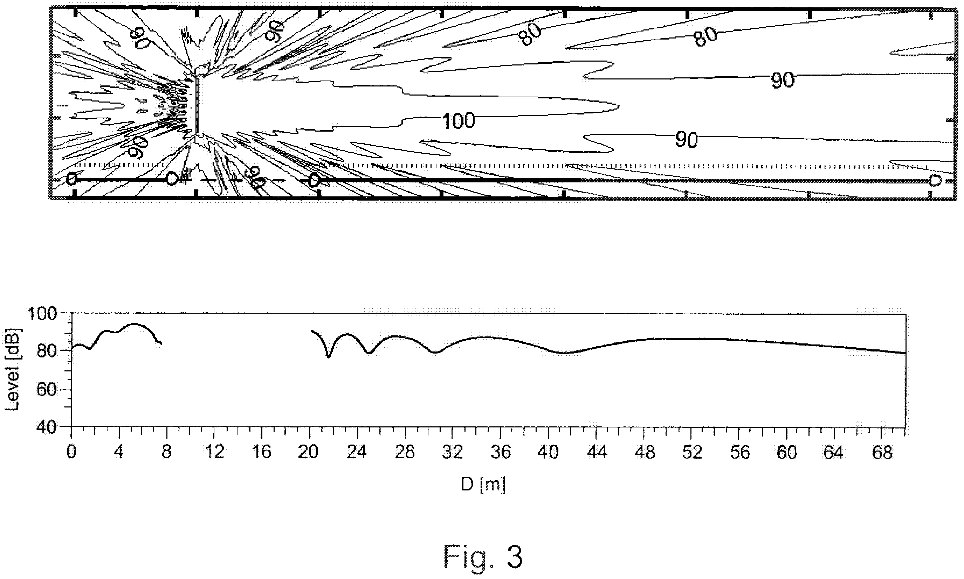

In Fig. 3 wird die nicht optimierte Standardkonfiguration des Beispiels dargestellt. Der obere Teil der Fig. 3 zeigt, genau wie in allen weiteren derartigen Figuren, die räumliche Schallpegelverteilung, in der Seitenansicht, bei einer Frequenz von 1000 Hz, während der untere Teil die Schallpegelverteilung auf dem linienförmigen Verbotsbereich (linke Kurve) und auf dem ebenfalls linienförmigen Hörbereich (rechte Kurve) zeigt. Der Verbots- und der Hörbereich sind im oberen Teil der Figur durch gestrichelte Linien dargestellt. Es ist deutlich erkennbar, dass ein Großteil der Schallleistung über den Hörbereich hinweg abgestrahlt wird, diesen also verfehlt. Die Schallpegelverteilung im Hörbereich ist durch Interferenzmuster geprägt, und der Schallpegel im Verbotsbereich ist ähnlich hoch wie im Hörbereich.

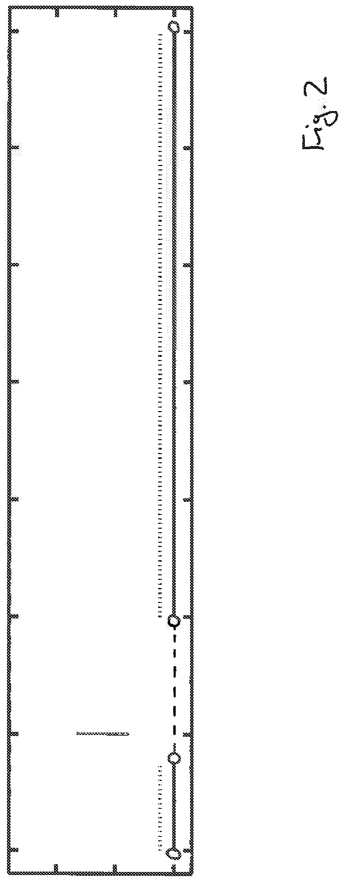

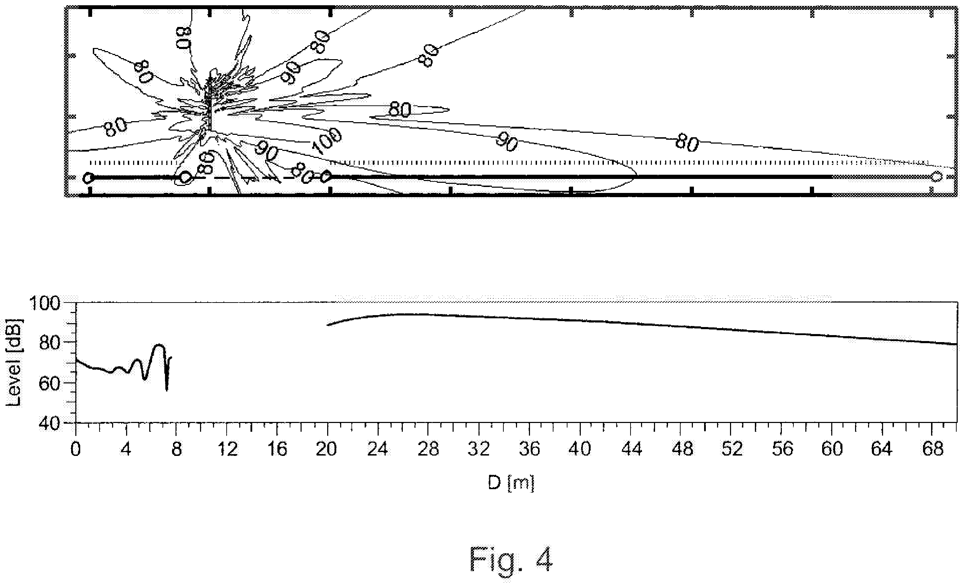

In Fig. 4 ist eine Konfigurationsvariante des Beispiels nach Fig. 2 mit maximierter mittlerer Schallleistung gezeigt, wobei die mittlere, den Schallwandlern zugeführte elektrische Leistung konstant gehalten wurde, also die mittlere, quadratische Verstärkung der Filter der Steuereinheit gleich bleibt. Erkennbar ist hier eine deutlich auf den Hörbereich gerichtete Abstrahlung. Die Schallpegelverteilung im Hörbereich ist glatt, aber nicht gleichmäßig. Der Schallpegel im Verbotsbereich ist aufgrund der optimierten Richtwirkung deutlich geringer als im Hörbereich.

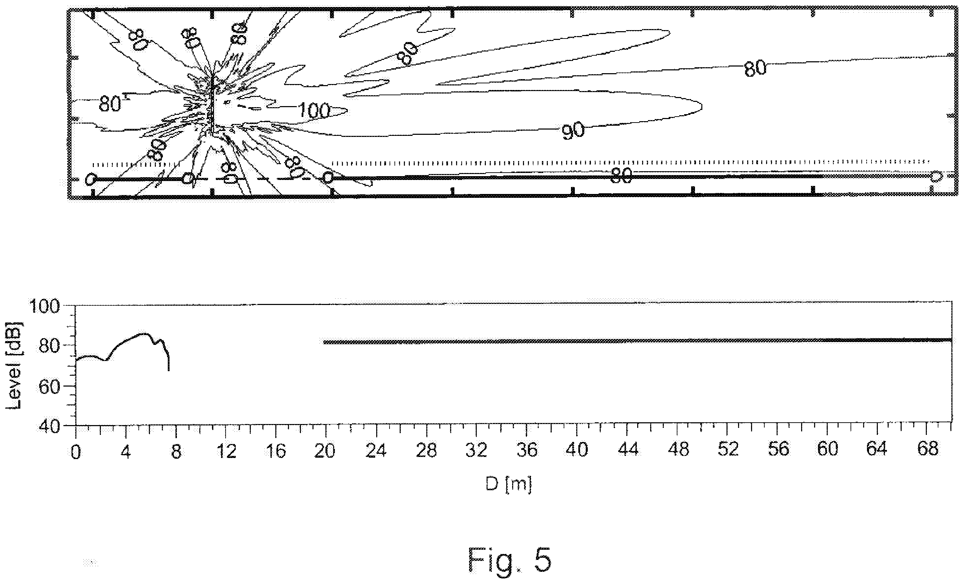

Fig. 5 zeigt eine Konfigurationsvariante des Beispiels nach Fig. 2 mit maximal gleichmäßiger Schallpegelverteilung im Hörbereich (optimiert nach dem Glattheitskriterium). Der Schallpegel im Hörbereich ist nahezu perfekt gleichverteilt. Im Verbotsbereich ist der Pegel ähnlich hoch wie im Hörbereich. Wie im nicht optimierten Fall wird ein Großteil der Leistung über den Hörbereich hinweg abgestrahlt.

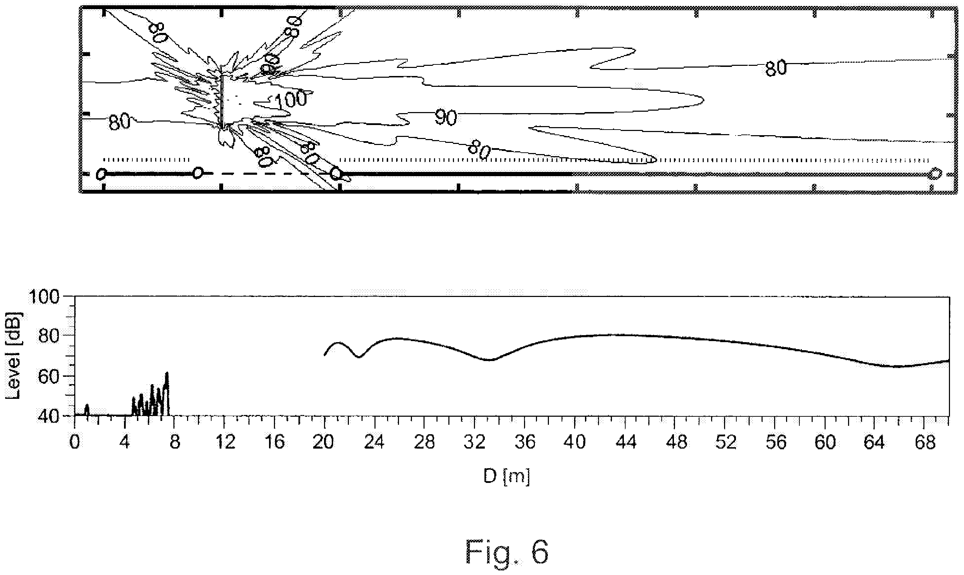

Zuletzt zeigt Fig. 6 eine Konfigurationsvariante des Beispiels mit minimaler Schallleistung im Verbotsbereich. In der Tat ist eine deutliche, wenn auch keinesfalls vollständige Aussparung des Verbotsbereichs erkennbar. Die Pegelabsenkung im Verbotsbereich im Vergleich zum Hörbereich ist beträchtlich.

Nachfolgend werden Ausführungsbeispiele beschreiben, bei denen die Zielfunktion einen oder mehrere schallfeldunabhängige Funktionsterme umfasst. Bestandteile der Zielfunktion können die Konfigurationsparameter der Lautsprecheranordnung selbst und / oder Funktionsterme sein, die von einem oder mehreren der Konfigurationsparameter abhängen, zum Beispiel Position und Ausrichtung der Lautsprecher oder die Filtereinstellungen für die Lautsprecher.

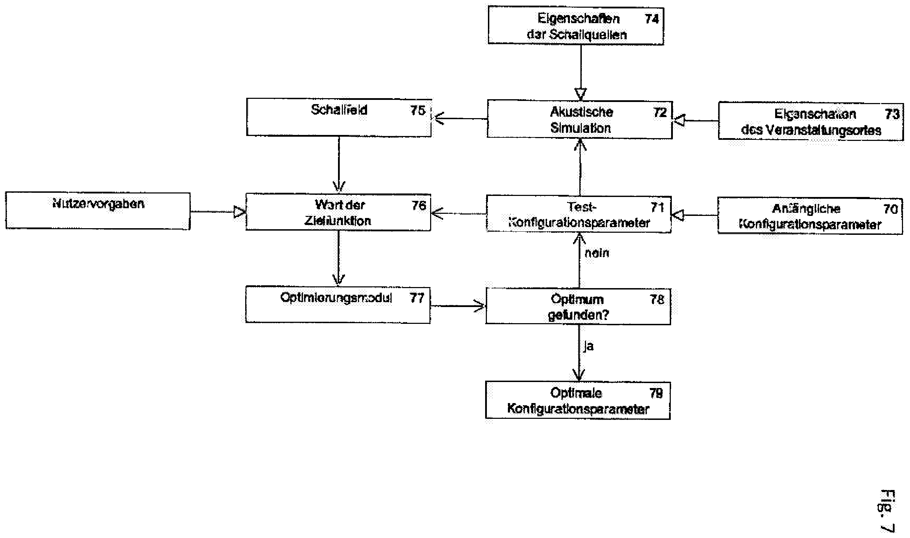

Fig. 7 zeigt eine schematische Darstellung eines Ablaufdiagramms für ein Computer-basiertes Verfahren zum Bestimmen einer Konfiguration einer Lautsprecheranordnung. Die Bestimmung der Konfiguration kann mit einer Software-Applikation auf einem Computer ausgeführt werden. Bei dem Verfahren zum automatisierten Bestimmen der Konfiguration für die mehrere Lautsprecherelemente umfassende Lautsprecheranordnung, mit der ein konkreter Raum zu beschallen ist, wird zunächst im Schritt 70 eine anfängliche Konfiguration mit anfänglichen Konfigurationsparametern bereitgestellt. Diese können zum Beispiel in elektronischer Form über eine Schnittstelle an den zur Optimierung genutzten Computer übergeben werden. Alternativ oder ergänzend kann vorgesehen sein, dass anfängliche Konfigurationsparameter, die bei dieser oder anderen Ausführungen ganz oder teilweise von experimentell gemessenen Werten abgeleitet sein können, vom Benutzer über eine Benutzerschnittstelle des Computers erfasst werden, beispielsweise mittels Tastatureingabe. Damit liegt gemäß Schritt 71 im Computer eine (erste) Kandidatenkonfiguration vor, die im Schritt 72 für eine akustische Simulation genutzt wird. Hierbei werden gemäß Schritten 73 und 74 Eigenschaften des zu beschallenden Raums, bei dem es sich beispielsweise um einen Veranstaltungsort oder -raum handelt, und Eigenschaften der benutzten Lautsprecher (Schallquellen) berücksichtigt. Hierbei wird ein Abstrahlungsmodell für die Anordnung aus Lautsprechern und Raum berücksichtigt. Ein solches Abstrahlungsmodell verwendet gemessene und / oder berechnete Daten, die insbesondere die Schallabstrahlung eines Lautsprechers charakterisieren, sowie dessen elektrische Ansteuerung, Anordnung und / oder Ausrichtung im Raum. Ergänzend kann der Raum selbst durch seine Begrenzungsflächen und / oder die verwendeten akustischen Wandmaterialien definiert werden. Ergebnis ist die zeit- und frequenzabhängige Schalldruckverteilung im gesamten Raum, also auch an definierten Empfangspunkten. Das Ausbilden eines Abstrahlungsmodells zu einer gegebenen Lautsprecheranordnung für einen zu beschallenden Raum ist als solches in verschiedenen Ausführungen bekannt und bedarf hier deshalb keiner weiteren Erläuterung.

Auf Basis der akustischen Simulation wird im Schritt 75 das Schallfeld für die aktuelle Kandidatenkonfiguration bestimmt. Im Anschluss wird im Schritt 76 für die zuvor festgelegte Zielfunktion ein Wert für das konkrete Schallfeld und die gegebenen Konfigurationsparameter bestimmt. Die verwendete Zielfunktion berücksichtigt neben einem oder mehreren schallfeldabhängigen Funktionstermen auch mindestens einen schallfeldunabhängigen, nichtakustischen Funktionsterm.

Das Optimierungsmodul 77 speichert den errechneten Wert der Zielfunktion nebst der zugehörigen Werte der Konfigurationsparameter. Im Schritt 78 wird überprüft, ob die aktuelle Kandidatenkonfiguration innerhalb einer vorgegebenen Toleranz einem lokalen Minimum der Zielfunktion entspricht. Ist dies nicht der Fall, wird gemäß dem Optimierungsalgorithmus aus der aktuellen Kandidatenkonfiguration, wahlweise unter ergänzender Berücksichtigung einer oder mehrerer vorher bestimmter Kandidatenkonfigurationen, eine neue Kandidatenkonfiguration bestimmt. Wurde hingegen ein lokales Minimum gefunden, werden elektronische Informationen betreffend die ausgewählte Konfiguration mit den Konfigurationsparametern erzeugt und zur Ausgabe auf dem Computer bereitgestellt (Schritt 79), worauf beispielsweise eine Anzeige auf dem Display des Computers erfolgen kann. Es kann auch vorgesehen sein, alternativ oder ergänzend von der ausgewählten Konfiguration ausgehend Steuersignale zu erzeugen und abzugeben, die dann über eine elektronische Schnittstelle von dem Computer an eine Steuereinrichtung der Lautsprecheranordnung gegeben werden.

Das beschriebene Verfahren kann mit Hilfe einer Software-Applikation automatisiert auf einem Computer oder einem Computersystem ausgeführt werden.

Im Folgenden werden Aspekte bezüglich der Einbeziehung schallfeldunabhängiger Funktionsterme in die Zielfunktion weiter beschrieben.

Zunächst wird der Aspekt "Entkopplung von Gesamtlautstärke" erläutert.

Die Zielfunktion kann durch Funktionsterme ergänzt werden, die es erlauben, den Bestandteil $P^{-1}$ von der Gesamtlautstärke zu entkoppeln. Es kann wünschenswert erscheinen, eine Zielfunktion als Summe von $P^{-1}$ und S zu bilden, doch es ist unmittelbar einsichtig, dass der Summand $P^{-1}$ sich bei veränderter Gesamtlautstärke, also bei veränderter mittlerer Filteramplitude, anders verhält als der Summand S, denn ersterer wächst quadratisch mit der reziproken Gesamtlautstärke, während letzterer unverändert bleibt. Das Ergebnis der Optimierung soll aber nicht von der Gesamtlautstärke abhängen, weswegen es erforderlich ist, dass alle Summanden der Zielfunktion von der Gesamtlautstärke unabhängig sind. Der Funktionsbestandteil $P^{-1}$ kann von der Gesamtlautstärke entkoppelt werden, indem er auf die Amplituden der Filterübertragungsfunktionen bezogen wird. Hierzu betrachtet man beispielsweise das gemittelte Filteramplitudenquadrat,

$$G(f, p_1, \ldots, p_N) = \frac{1}{N_F} \sum_{i=1}^{N_F} |h_i(f, p_1, \ldots, p_N)|^2,$$

wobei $h_i(f, p_1, \ldots, p_N)$ jeweils für $i = 1, \ldots, N_F$ die Übertragungsfunktion des $i$-ten Filters beschreibt. Also ist $G(f, p_1, \ldots, p_N)$ ein schallfeldunabhängiger Funktionsterm. Auf diese Weise lässt sich eine Zielfunktion, die eine Summe aus einem Schallleistungs- und einem Glattheitskriterium darstellt und deren Summanden von der Gesamtlautstärke unabhängig sind, wie folgt formulieren:

$$F(f, p_1, \ldots, p_N) = c_1 F_1(f, p_1, \ldots, p_N) + c_2 F_2(f, p_1, \ldots, p_N)$$

mit

$$F_1(f, p_1, \ldots, p_N) = \frac{G(f, p_1, \ldots, p_N)}{P(f, p_1, \ldots, p_N)}$$

und

$$F_2(f, p_1, \ldots, p_N) = S(f, p_1, \ldots, p_N)$$

sowie Faktoren $c_1$ und $c_2$ zur Gewichtung der einzelnen Kriterien.

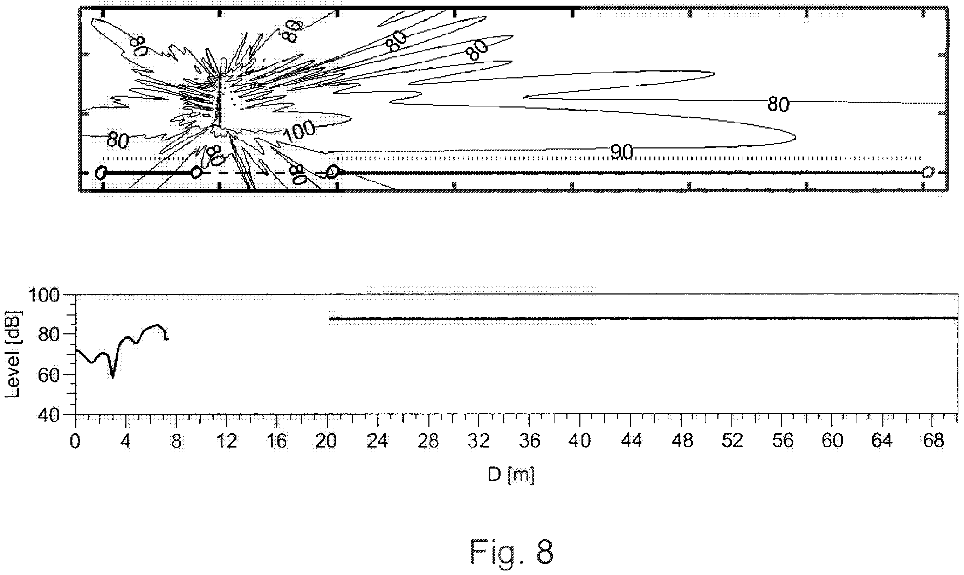

Fig. 8 zeigt eine Konfigurationsvariante für das Beispiel nach Fig. 2, bei der obige Zielfunktion mit $c_1 = 1$ und $c_2 = 1$ optimiert wurde. Es ist eine deutlich gerichtete Abstrahlung auf den Hörbereich bei gleichzeitig sehr gleichmäßiger Schallpegelverteilung im Hörbereich erkennbar.

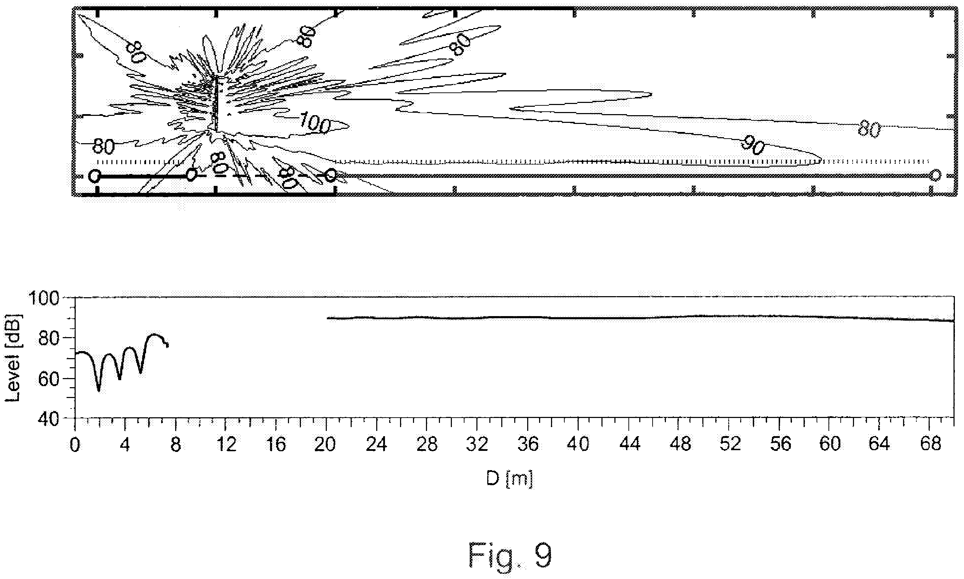

Fig. 9 illustriert für das gewählte Beispiel den Fall einer Optimierung der Zielfunktion mit $c_1 = 100$ und $c_2 = 1$. Das Leistungskriterium wird hier also stärker gewichtet. Die Verschiebung der Gewichtung der Kriterien manifestiert sich im Optimierungsergebnis: Die Richtwirkung der Abstrahlung ist im Vergleich zum vorherigen Fall noch deutlich verbessert, aber mit erkennbaren Einbußen bezüglich der Gleichmäßigkeit der Pegelverteilung.

Im Folgenden wird der Aspekt "Entkopplung der Verbotszonen von Gesamtlautstärke" erläutert.

In einer darauf basierenden günstigen Ausbildung können auch Verbotszonen besser in die Zielfunktion eingebunden werden. Analog zum normierten Schallleistungskriterium lässt sich der Zielfunktion ein weiterer normierter Summand hinzufügen, dessen Minimierung eine Verminderung der Schallabstrahlung auf die Verbotszonen bewirkt:

$$F_3(f, p_1, \ldots, p_N) = \frac{\tilde{P}(f, p_1, \ldots, p_N)}{G(f, p_1, \ldots, p_N)}.$$

Damit erhält man folgende erweiterte Zielfunktion:

$$F(f, p_1, \ldots, p_N) = c_1 F_1(f, p_1, \ldots, p_N) + c_2 F_2(f, p_1, \ldots, p_N) + c_3 F_3(f, p_1, \ldots, p_N)$$

mit Gewichtsfaktoren $c_1$, $c_2$ und $c_3$.

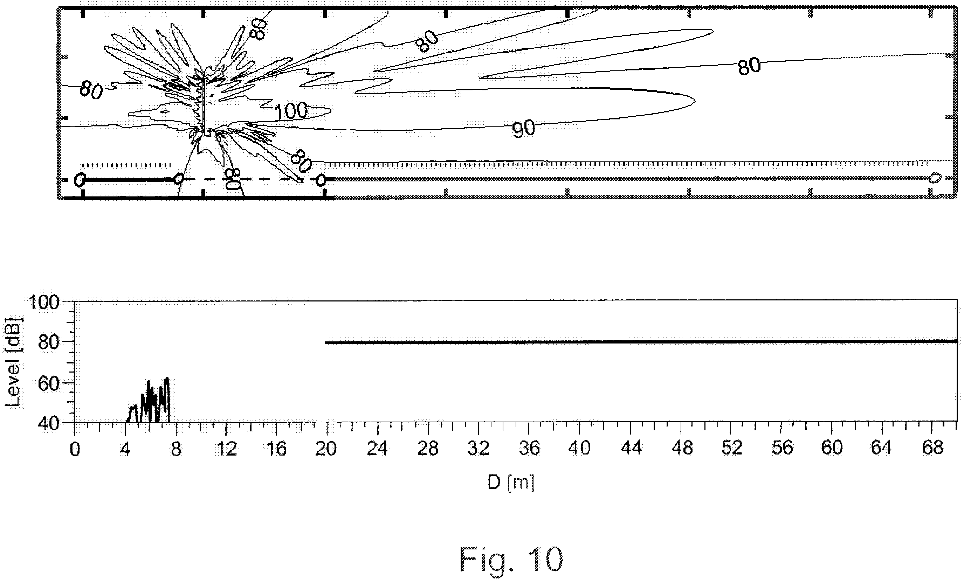

In Fig. 10 ist für das Beispiel das Ergebnis der Optimierung dieser Funktion für $c_1 = 0$, $c_2 = 1$ und $c_3 = 1$ dargestellt. Man erkennt starke Gleichmäßigkeit der Schallpegelverteilung im Hörbereich bei gleichzeitig starker Pegelabsenkung im Verbotsbereich.

Nachfolgenden wird der Aspekt "Gleichmäßigkeit von Filteramplituden" erläutert.

Es kann die Einführung eines Funktionsbestandteils vorgesehen sein, der die Verhältnisse der Filteramplituden zueinander vergleicht. Wird in der Zielfunktion eine möglichst gleichmäßige Filteramplitude für alle Übertragungswege (Lautsprecher bzw. Lautsprecherkanäle) gefordert, so lassen sich interessanterweise höhere Gesamtpegel erreichen bei ansonsten annähernd gleicher Qualität.

$$F_4(f, p_1, \ldots, p_N) = \frac{\max_i |h_i(f, p_1, \ldots, p_N)|^2}{G(f, p_1, \ldots, p_N)}.$$

Auch hier wird mittels der Normierung durch den schallfeldunabhängigen Funktionsterm $G(f,p_1,\ldots,p_N)$ eine Unabhängigkeit von der Gesamtlautstärke erreicht. In praktischen Implementierungen kann es erforderlich sein, die Maximumsfunktion max(), die nicht notwendigerweise überall im Konfigurationsparameterraum stetig differenzierbar bezüglich der Konfigurationsparameter ist, durch eine stetig differenzierbare Funktion zu approximieren, da die stetige Differenzierbarkeit der Zielfunktion für viele Optimierungsalgorithmen Voraussetzung ist. Die Zielfunktion lässt sich nun abermals erweitern:

$$F(f, p_1, \ldots, p_N) = c_1 F_1(f, p_1, \ldots, p_N) + c_2 F_2(f, p_1, \ldots, p_N) + c_3 F_3(f, p_1, \ldots, p_N) + c_4 F_4(f, p_1, \ldots, p_N)$$

mit Gewichtsfaktoren $c_1$, $c_2$, $c_3$ und $c_4$.

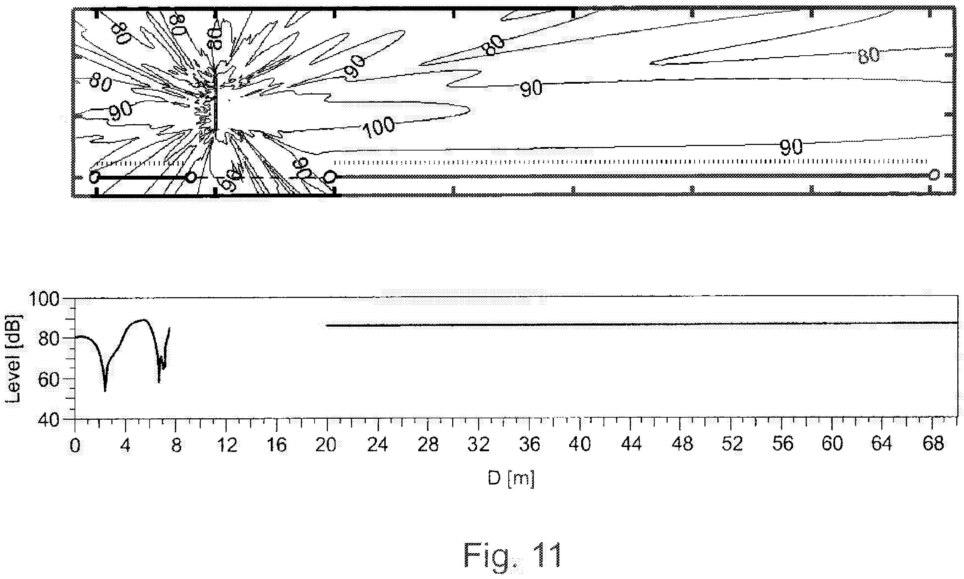

Das Ergebnis der Optimierung dieser Funktion mit $c_1 = 0$, $c_2 = 1$, $c_3 = 0$ und $c_4 = 0{,}01$, also unter Berücksichtigung des Glattheitskriteriums und des Gleichmäßigkeitskriteriums der Filteramplituden, wird in Fig. 11 für das Beispiel gezeigt. Der Pegelverlauf im Hörbereich ist wieder äußerst gleichmäßig. Zusätzlich ist der Gesamtpegel um etwa 5 dB höher als beim in Fig. 5 dargestellten Fall, der sich von dem hier gezeigten nur durch $c_4 = 0$ unterscheidet.

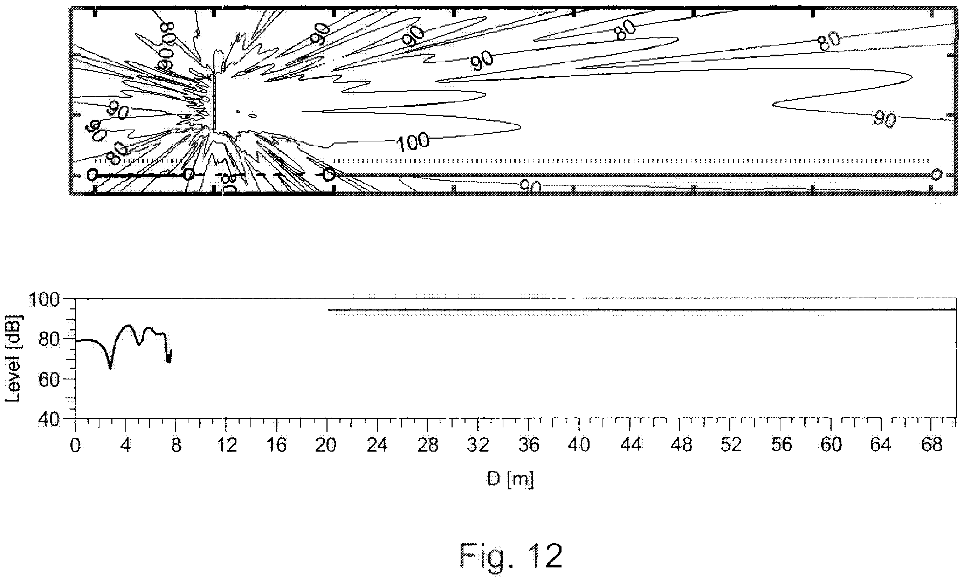

Der Gesamtpegel lässt sich in dem hier behandelten Beispiel noch um fast 10 dB weiter erhöhen, wenn das normierte Schallleistungskriterium hinzugefügt wird. Optimiert man obige Zielfunktion mit $c_1 = 1$, $c_2 = 1$, $c_3 = 0$ und $c_4 = 0{,}01$, so erhält man das in Fig. 12 dargestellte Ergebnis. Die Anhebung des Schallpegels im Vergleich zum vorherigen Fall erfolgt ohne nennenswerte Verluste bezüglich der Gleichmäßigkeit des Schallpegels im Hörbereich. Auch in diesem Fall ist das Gleichmäßigkeitskriterium der Filteramplituden für die Höhe des Gesamtpegels in signifikantem Umfang mitverantwortlich. Im Vergleich zum in Fig. 8 gezeigten Fall, der sich von dem hier gezeigten nur durch $c_4 = 0$ unterscheidet, ist der Gesamtpegel um mehr als 5 dB erhöht, ohne erkennbare Einbußen bezüglich der übrigen Kriterien.

Die bisher gezeigten Beispiele zeigen eine sehr gute gleichzeitige Optimierbarkeit der verschiedenen Kriterien. Zusätzlich ist eine Feinabstimmung des bei der Optimierung gefundenen Kompromisses zwischen den verschiedenen Anforderungen durch Veränderung der zugehörigen Gewichtsfaktoren ggf. frequenzabhängig möglich.

Nachfolgenden wird der Aspekt "Gleichmäßigkeit des Filterfrequenzverlaufs" erläutert.

Es kann der Frequenzverlauf der Filterfunktionen in der Zielfunktion berücksichtigt werden. Für eine günstige numerische und signaltechnische Behandlung sollten sich Amplitude und Phase der Filterfunktion über der Frequenz nicht zu stark verändern. Es lässt sich nun ein schallfeldunabhängiger Funktionsbestandteil in der Zielfunktion einführen, der die Sprungweite der Filterfrequenzgänge von einer Frequenz $f_{i-1}$ zur nächsten Frequenz $f_i$ bewertet, wiederum geeignet für Unabhängigkeit von der Gesamtlautstärke normiert:

$$F_5(f_i, p_1, \ldots, p_N) = \frac{\sum_{j=1}^{N_F} \left| h_j(f_i, p_1, \ldots, p_N) - h_j(f_{i-1}) \right|^{2n}}{G^n(f_i, p_1, \ldots, p_N)}$$

mit einem ganzzahligen Exponenten $n \geq 1$.

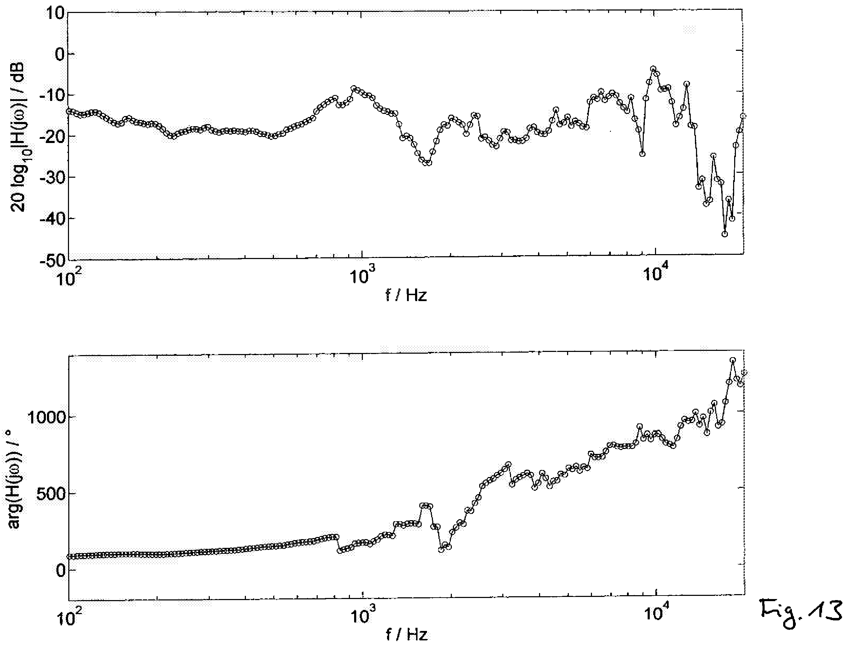

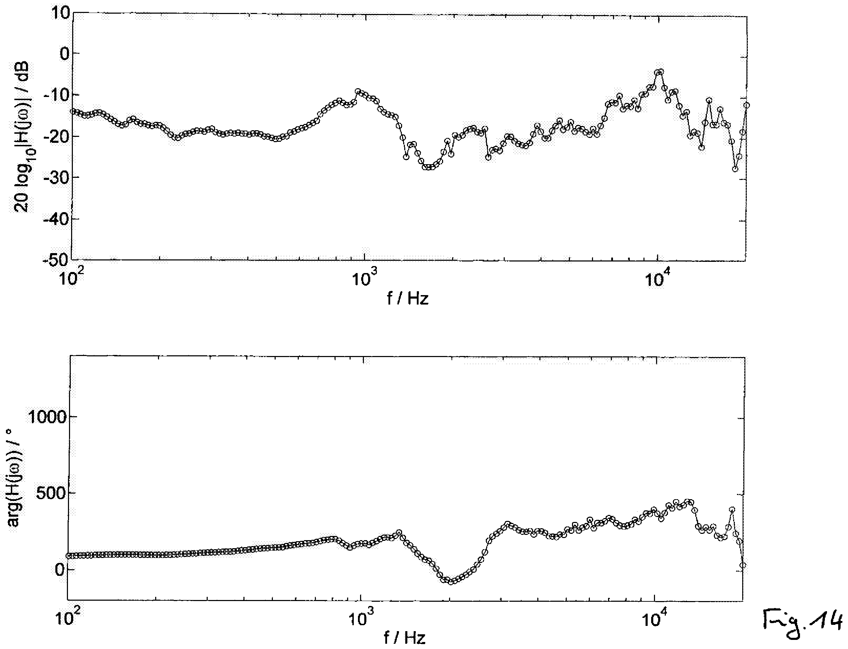

Fig. 13 zeigt exemplarisch den Verlauf einer Filterübertragungsfunktion, die das Ergebnis einer Optimierung ist, bei der der Funktionsbestandteil $F_5$ nicht in der Zielfunktion vertreten ist. Zum Vergleich wird die Übertragungsfunktion desselben Filterkanals in Fig. 14 gezeigt als Ergebnis einer Optimierung unter Verwendung des Funktionsbestandteils $F_5$ bei ansonsten gleicher Zielfunktion. Letztere Übertragungsfunktion zeigt ein deutlich weniger sprunghaftes Verhalten als die erstere.

Im Folgenden wird der Aspekt "Position und / oder Winkelung" erläutert.

Es kann die Einbeziehung anderer Konfigurationsparameter in die Zielfunktion vorgesehen sein, zum Beispiel Position und / oder Winkelung der Lautsprecher. Es kann mechanisch von Vorteil sein, wenn eine bestimmte Lage und Ausrichtung gewählt wird. Dem können Qualitätskriterien mit einer Gewichtung gegenübergestellt werden. Beispielsweise lässt sich für ein aus mehreren Lautsprecherboxen zusammengesetztes Lautsprechersystem, ein Funktionsbestandteil

$$F_6(p_1, \ldots, p_N) = \sum_{i=1}^{N_L - 1} \alpha_i^2 (p_1, \ldots, p_N)$$

definieren, wobei $\alpha_i(p_1,\ldots,p_N)$ für alle $i = 1,\ldots,N_L$ - 1 jeweils den Zwischenwinkel zwischen der *i*-ten und der *i* + 1-ten Box angibt.

Die in der vorstehenden Beschreibung, den Ansprüchen und der Zeichnung offenbarten Merkmale der Erfindung können sowohl einzeln als auch in beliebiger Kombination für die Verwirklichung der Erfindung in ihren verschiedenen Ausführungsformen von Bedeutung sein.

**Patentansprüche**

1. Verfahren zum Bestimmen einer Konfiguration für eine Lautsprecheranordnung zum Beschallen eines Raums, wobei das Verfahren die folgenden Schritte aufweist:

   - Bereitstellen einer anfänglichen Konfiguration mit anfänglichen Konfigurationsparametern für eine Lautsprecheranordnung zum Beschallen eines Raums in einem Computer,
   - Bestimmen von Kandidatenkonfigurationen mit jeweils zugeordneten Konfigurationsparametern mit Hilfe eines zielfunktionsbasierten Optimierungsverfahrens, bei dem, ausgehend von der anfänglichen Konfiguration, in dem Computer iterativ

      - zu einer Kandidatenkonfiguration ein Schallfeld für den zu beschallenden Raum und / oder Teile hiervon mittels Simulation bestimmt wird,
      - ein der Kandidatenkonfiguration und dem simulierten Schallfeld zugeordneter Wert einer Zielfunktion bestimmt wird und
      - eine neue Kandidatenkonfiguration für die Lautsprecheranordnung gewählt wird, und

   - Auswählen einer Konfiguration mit Konfigurationsparametern aus den iterativ bestimmten Kandidatenkonfigurationen in Abhängigkeit von wenigstens einem Auswahlkriterium, welches zumindest die Werte der Zielfunktion berücksichtigt,

   **dadurch gekennzeichnet, dass** die bei dem Optimierungsverfahren verwendete Zielfunktion sowohl einen oder mehrere schallfeldabhängigen Funktionstermen wie auch einen schallfeldunabhängigen Funktionsterm aufweist, welcher von wenigstens einem Teil der Konfigurationsparameter aber nicht vom simulierten Schallfeld abhängt.

2. Verfahren nach Anspruch 1, **dadurch gekennzeichnet, dass** der schallfeldunabhängige Funktionsterm und / oder ein anderer schallfeldunabhängiger Funktionsterm abhängig sind von mindestens einem Filterparameter für einen Filter in einer Steuereinrichtung zum Ansteuern der Lautsprecheranordnung.

3. Verfahren nach Anspruch 1 oder 2, **dadurch gekennzeichnet, dass** der schallfeldunabhängige Funktionsterm und / oder der andere schallfeldunabhängige Funktionsterm abhängig sind von der Glattheit des Frequenzganges eines oder mehrerer Filter in der Steuereinrichtung zum Ansteuern der Lautsprecheranordnung.

4. Verfahren nach mindestens einem der vorangehenden Ansprüche, **dadurch gekennzeichnet, dass** der schallfeldunabhängige Funktionsterm und / oder der andere schallfeldunabhängige Funktionsterm abhängig sind von einer räumlichen Position eines oder mehrerer Lautsprecherelemente der Lautsprecheranordnung.

5. Verfahren nach mindestens einem der vorangehenden Ansprüche, **dadurch gekennzeichnet, dass** der schallfeldunabhängige Funktionsterm und / oder der andere schallfeldunabhängige Funktionsterm abhängig sind von einer räumliche Ausrichtung eines oder mehrerer Lautsprecherelemente der Lautsprecheranordnung.

6. Verfahren nach mindestens einem der vorangehenden Ansprüche, **dadurch gekennzeichnet, dass** die Zielfunktion mehrere Funktionsbestandteile aufweist, wobei zumindest einer der mehreren Funktionsbestandteile nur von dem schallfeldunabhängigen Funktionsterm und / oder dem anderen schallfeldunabhängigen Funktionsterm abhängig ist.

7. Verfahren nach mindestens einem der vorangehenden Ansprüche, **dadurch gekennzeichnet, dass** die Zielfunktion einen Funktionsbestandteil aufweist, mit dem, bei gegebener Kandidatenkonfiguration für die Lautsprecheranordnung, eine Abweichung des Schallpegels in einem Teilbereich des Raumes von einem Sollwert bewertet wird.

8. Verfahren nach mindestens einem der vorangehenden Ansprüche, **dadurch gekennzeichnet, dass** die Zielfunktion einen Funktionsbestandteil aufweist, mit dem, bei gegebener Kandidatenkonfiguration für die Lautsprecheranordnung und unabhängig von einer Gesamtlautstärke, die Höhe des Schallpegels in einem Teilbereich des Raumes bewertet wird.

9. Verfahren nach mindestens einem der vorangehenden Ansprüche, **dadurch gekennzeichnet, dass** die Zielfunktion einen Funktionsbestandteil aufweist, mit dem, bei gegebener Kandidatenkonfiguration für die Lautsprecheranordnung und unabhängig von der Gesamtlautstärke, eine Minimierung der Schallabstrahlung in einen anderen Teilbereich des Raumes bewertet wird.

10. Verfahren nach mindestens einem der vorangehenden Ansprüche, **dadurch gekennzeichnet, dass** die Zielfunktion einen Funktionsbestandteil aufweist, mit dem die Gleichmäßigkeit einer elektrischen Lastverteilung auf zumindest einen Teil der Lautsprecherelemente der Lautsprecheranordnung bewertet wird und der nur von einem oder mehreren schallfeldunabhängigen Funktionstermen abhängt.

11. Verfahren nach mindestens einem der vorangehenden Ansprüche, **dadurch gekennzeichnet, dass** im Computer, von der ausgewählten Konfiguration ausgehend, Steuerungsdaten für die Steuereinrichtung zum Ansteuern der Lautsprecheranordnung erzeugt und an einer Schnittstelle bereitgestellt werden.

12. Computerprogramm-Produkt mit Programmcode, welcher wahlweise auf einem computerlesbaren Speichermedium gespeichert und geeignet ist, beim Ablauf auf einer Rechenvorrichtung ein Verfahren nach mindestens einem der vorangehenden Ansprüche auszuführen.

**Claims**

1. A method for determining a configuration for a loudspeaker arrangement to provide sound to a room, wherein the method comprises the following steps:

   - providing an initial configuration with initial configuration parameters for a loudspeaker arrangement to provide sound to a room, in a computer,
   - determining candidate configurations with respectively assigned configuration parameters with the aid of a target-function-based optimising procedure, in which in the computer, starting with the initial configuration, iteratively,

     - a sound field for a candidate configuration is determined by means of simulation for the room and/or for parts of the room, in which sound is to be provided,
     - a value of a target function is determined, which is assigned to the candidate configuration and the simulated sound field, and
     - a new candidate configuration for the loudspeaker arrangement is chosen, and
   - selecting a configuration with configuration parameters from the iteratively determined candidate configurations as a function of at least one selection criterion, which takes at least the values of the target function into account,

   **characterised in that** the target function used in the optimising procedure comprises one or more sound-field-dependent function terms as well as a sound-field-independent function term, which is dependent on at least a part of the configuration parameters but not on the simulated sound field.

2. The method according to claim 1, **characterised in that** the sound-field-independent function term and/or another sound-field-independent function term are dependent on at least one filter parameter for a filter in a control device for controlling the loudspeaker arrangement.

3. The method according to claim 1 or 2, **characterised in that** the sound-field-independent function term and/or the other sound-field-independent function term are dependent on the smoothness of the frequency response of one or more filters in the control device for controlling the loudspeaker arrangement.

4. The method according to at least one of the preceding claims, **characterised in that** the sound-field-independent function term and/or the other sound-field-independent function term are dependent on a spatial position of one or more loudspeaker elements of the loudspeaker arrangement.

5. The method according to at least one of the preceding claims, **characterised in that** the sound-field-independent function term and/or the other sound-field-independent function term are dependent on a spatial alignment of one or more loudspeaker elements of the loudspeaker arrangement.

6. The method according to at least one of the preceding claims, **characterised in that** the target function comprises a number of function components, wherein at least one of a number of function components is dependent only on the sound-field-independent function term and/or the other sound-field-independent function term.

7. The method according to at least one of the preceding claims, **characterised in that** the target function comprises a function component, which, for a given candidate configuration of a loudspeaker arrangement, is provided to rate a deviation of the volume of sound from a set value in a section of the room.

8. The method according to at least one of the preceding claims, **characterised in that** the target function comprises a function component, which, for a given candidate configuration of a loudspeaker arrangement and independently of a total volume of sound, is provided to rate the level of the volume of sound in a section of the room.

9. The method according to at least one of the preceding claims, **characterised in that** the target function comprises a function component, which, for a given candidate configuration of a loudspeaker arrangement and independently of the total volume of sound, is provided to rate a minimisation of the sound emission into another section of the room.

10. The method according to at least one of the preceding claims, **characterised in that** the target function comprises a function component, which is provided to rate the uniformity of an electrical load distribution across at least a part of the loudspeaker elements of the loudspeaker arrangement and which is dependent only on one or more sound-field-independent function terms.

11. The method according to at least one of the preceding claims, **characterised in that** in the computer, on the basis of the selected configuration, control data is generated for the control device for controlling the loudspeaker arrangement and provided at an interface.

12. A computer program product with program code which is optionally stored in a computer-readable storage medium and is suitable when run on a computing device to execute a method according to least one of the preceding claims.

**Revendications**

1. Procédé de détermination d'une configuration pour un dispositif de haut-parleur pour insonifier un espace, dans lequel le procédé présente les étapes suivantes consistant à :

   - fournir une configuration de départ avec des paramètres de configuration de départ pour un dispositif de haut-parleur pour insonifier un espace dans un ordinateur ;
   - déterminer des configurations candidates avec des paramètres de configuration respectivement coordonnés à l'aide d'un procédé d'optimisation basé sur fonction cible, dans lequel, à partir de la configuration de départ, dans l'ordinateur itérativement

      - pour une configuration candidate un champ sonore pour l'espace à insonifier et/ou des parties de celui-ci est déterminé au moyen d'une simulation,
      - une valeur d'une fonction cible coordonnée à la configuration candidate et au champ sonore simulé est déterminée et
      - une nouvelle configuration candidate pour le dispositif de haut-parleur est sélectionnée et

   - sélectionner une configuration avec des paramètres de configuration d'après les configurations candidates déterminées itérativement en fonction d'au moins un critère de sélection, qui prend en compte au moins les valeurs de la fonction cible,

**caractérisé en ce que** la fonction cible utilisée lors du processus le procédé d'optimisation présente tant un ou plusieurs termes de fonctions dépendant du champ sonore qu'un terme de fonction indépendant du champ sonore qui dépend au moins d'une partie des paramètres de configuration mais pas du champ sonore simulé.

2. Procédé selon la revendication 1, **caractérisé en ce que** le terme de fonction indépendant du champ sonore et/ou un autre terme de fonction indépendant du champ sonore sont dépendants d'au moins un paramètre de filtre pour un filtre dans un dispositif de commande pour commander le dispositif de haut-parleur.

3. Procédé selon la revendication 1 ou 2, **caractérisé en ce que** le terme de fonction indépendant du champ sonore et/ou d'autres termes de fonction indépendants du champ sonore sont dépendants du lissé de la réponse de fréquence d'un ou plusieurs filtres dans le dispositif de commande pour commander le dispositif de haut-parleur.

4. Procédé selon au moins une des revendications précédentes, **caractérisé en ce que** le terme de fonction indépendant du champ sonore et/ou d'autres termes de fonction indépendants du champ sonore sont dépendants d'une position spatiale d'un ou plusieurs éléments de haut-parleur dans le dispositif de commande pour commander le dispositif de haut-parleur.

5. Procédé selon au moins une des revendications précédentes, **caractérisé en ce que** le terme de fonction indépendant du champ sonore et/ou d'autres termes de fonction indépendants du champ sonore sont dépendants d'une orientation spatiale d'un ou plusieurs éléments de haut-parleur dans le dispositif de commande pour commander le dispositif de haut-parleur.

6. Procédé selon au moins une des revendications précédentes, **caractérisé en ce que** la fonction cible présente plusieurs composantes de la fonction, dans lequel au moins une des plusieurs composantes de la fonction dépend seulement du terme de fonction indépendant du champ sonore et/ou de l'autre terme de fonction indépendant du champ sonore.

7. Procédé selon au moins une des revendications précédentes, **caractérisé en ce que** la fonction cible présente une composante de la fonction, avec laquelle, en présence d'une configuration candidate donnée pour le dispositif de haut-parleur, un écart du niveau de son dans une zone partielle de l'espace par rapport à une valeur de consigne est estimé.

8. Procédé selon au moins une des revendications précédentes, **caractérisé en ce que** la fonction cible présente une composante de la fonction, avec laquelle, en présence d'une configuration candidate donnée pour le dispositif de haut-parleur et indépendamment d'un volume sonore total, la hauteur du niveau de son dans une zone partielle de l'espace est estimée.

9. Procédé selon au moins une des revendications précédentes, **caractérisé en ce que** la fonction cible présente une composante de la fonction, avec laquelle, en présence d'une configuration candidate donnée pour le dispositif de haut-parleur et indépendamment d'un volume sonore total, une minimisation de la diffusion du son dans une autre zone partielle de l'espace est estimée.

10. Procédé selon au moins une des revendications précédentes, **caractérisé en ce que** la fonction cible présente une composante de la fonction, avec laquelle l'uniformité d'une répartition de charge électrique sur au moins une partie des éléments de haut-parleurs du dispositif de haut-parleur est estimée et qui dépend seulement d'un ou plusieurs termes de la fonction indépendante du champ sonore.

11. Procédé selon au moins une des revendications précédentes, **caractérisé en ce que** dans l'ordinateur, à partir de la configuration sélectionnée, des données de commande pour le dispositif de commande sont générées afin de commander le dispositif de haut-parleur et sont fournies à une interface.

12. Produit de programme informatique avec un code de programme, qui est mémorisée au choix sur un support de mémorisation lisible par ordinateur et convient pour mettre en oeuvre, lors du déroulement d'un dispositif informatique, un procédé selon au moins une des revendications précédentes.

Fig. 1

Fig. 2

EP 2 965 538 B1

Fig. 3

Fig. 4

Fig. 5

Fig. 6

Eigenschaften 74
der Schallquellen

Schallfeld 75

Akustische 72
Simulation

Eigenschaften 73
des Veranstaltungsortes

Nutzervorgaben

Wert der 76
Zielfunktion

Test- 71
Konfigurationsparameter

Anfängliche 70
Konfigurationsparameter

nein

Optimierungsmodul 77

Optimum 78
gefunden?

ja

Optimale 79
Konfigurationsparameter

Fig. 7

Fig. 8

Fig. 9

Fig. 10

Fig. 11

Fig. 12

25

Fig. 13

Fig. 14

**EP 2 965 538 B1**

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2008047089 A2
- EP 1355514 A2
- WO 2011080499 A1
- US 20090144036 A1

**In der Beschreibung aufgeführte Nicht-Patentliteratur**

- Objective Function. **BEISPIEL S. BOYD ; L. VANDENBERGHE.** Convex Optimization. Cambridge University Press, 2009
- **MARTIN AUDIO.** *The Edge,* April 2005